# FASCICULE DE BREVET EUROPEEN

(11) **EP 3 363 035 B1**
(45) Date de publication et mention de la délivrance du brevet: **09.10.2019**
(21) Numéro de dépôt: 16782232.9
(22) Date de dépôt: 17.10.2016
(51) Int. Cl.: H01H 25/00, G05G 9/02, G05G 5/03

(54) **DISPOSITIF DE COMMANDE ÉLECTRONIQUE POUR VÉHICULE AUTOMOBILE**
ELEKTRONISCHE STEUERUNGSVORRICHTUNG FÜR EIN KRAFTFAHRZEUG
ELECTRONIC CONTROL DEVICE FOR A MOTOR VEHICLE

(30) Priorité: 16.10.2015 FR 1559850
(43) Date de publication de la demande: 22.08.2018
(73) Titulaire: DAV, 94046 Créteil Cedex (FR)
(72) Inventeur: LACOUR, Denis, 94046 Créteil Cedex (FR)
(74) Mandataire: Delplanque, Arnaud
(86) Numéro de dépôt international: PCT/EP2016/074910
(87) Numéro de publication internationale: WO 2017/064331

(56) Documents cités:
- EP-A1- 2 267 742
- DE-B3-102008 024 120
- US-A1- 2006 131 140

## Description

La présente invention concerne un dispositif de commande électrique pour véhicule automobile, telle que pour l'ouverture et/ou la fermeture d'un ouvrant ou la commande d'un lève-vitre.

Certains modules de commande électrique comprennent une manette de commande actionnable en coulissement et en rotation pour la commande d'un ouvrant ou un lève-vitre de véhicule automobile. La manette est montée dans un coulisseau, lui-même monté en rotation dans un support du module de commande. Les mouvements en pivotement et translation de la manette sont transformés en signaux électriques de commande.

Ce module peut toutefois s'avérer couteux à mettre en oeuvre et peut présenter un encombrement important, notamment afin d'inclure le mécanisme permettant au coulisseau de pivoter. L'encombrement et le coût augmentent encore lorsqu'on prévoit un mécanisme d'indexage des mouvements de translation avant/arrière et/ou bascule avant/arrière.

Par ailleurs, le mécanisme peut s'avérer complexe car les mouvements de translation ne doivent pas interférer avec les mouvements de bascule et vice-versa.

En outre, le suivi des déplacements en pivotement et en translation du module par un ou plusieurs capteurs pour les traduire en signaux électriques de commande au cours des déplacements, peut être délicat à mettre en oeuvre.

On connaît par exemple de EP 2 267 742 A un dispositif selon le préambule de la revendication 1.

Un des buts de la présente invention est de proposer un dispositif de commande électrique pour véhicule automobile pouvant être actionné en pivotement et en translation et qui soit moins couteux, plus simple et plus compact que ceux de l'état de la technique.

A cet effet, l'invention a pour objet un dispositif de commande électrique pour véhicule automobile comprenant un socle caractérisé en ce qu'il comporte :
- un levier dont une première extrémité porte une manette et une deuxième extrémité porte au moins un suiveur de came,
- un premier et un deuxième chariots mobiles en translation dans le socle, le levier étant monté pivotant dans le premier chariot et coopérant avec le deuxième chariot de manière que la rotation de la manette entraine une translation du deuxième chariot dans le socle et de manière que la translation de la manette entraine une translation du deuxième chariot dans le socle, et
- au moins une surface de came présentant une première rainure de guidage d'orientation rectiligne et une deuxième rainure de guidage s'inscrivant dans une forme circulaire, les rainures de guidage étant sécantes, le levier coopérant avec la surface de came et le premier et le deuxième chariots pour que la rotation du levier entraine le déplacement en translation du deuxième chariot dans le socle et pour que la translation du levier entraine en translation les deux chariots dans le socle.

La forme en croix (ou en « V » ou en « Y ») de la surface de came permet une sélection du déplacement du levier, soit en translation, soit en pivotement. On peut ainsi gérer jusqu'à quatre mouvements de la manette avec des indexages spécifiques sans que l'un des mouvements ne vienne interférer avec l'autre lors de l'actionnement du dispositif. En outre, la rotation du levier est transformée en déplacement linéaire, permettant au dispositif de commande électrique de s'animer par des coulissements de chariots, simples à réaliser. L'utilisation d'une surface de came et de chariots permet de réduire de façon importante le nombre de pièces du dispositif de commande électrique et donc son encombrement et son coût.

Selon une ou plusieurs caractéristiques du dispositif de commande électrique, prise seule ou en combinaison,
- une rainure de guidage rencontre l'autre rainure de guidage en son milieu,
- une rainure de guidage rencontre l'autre rainure de guidage à une de ses extrémités,
- au moins une rainure de guidage comporte au moins un creux et/ou un relief d'indexage,
- la surface de came est ménagée dans une plaquette montée et fixée dans un socle du dispositif de commande électrique,
- le levier et le deuxième chariot comportent au moins un orifice oblong et au moins un pion cylindrique, l'orifice oblong s'étendant dans un plan orthogonal à la direction transversale et coopérant avec le pion cylindrique saillant dans la direction transversale,
- le levier comporte une embase en forme générale d'équerre dont une première extrémité porte la manette et une deuxième extrémité présente une forme de tube, portant deux suiveurs de came symétriquement opposés coopérant avec une surface de came respective,
- le dispositif de commande électrique comporte au moins un premier capteur optique apte à coopérer avec au moins un cache du premier chariot pour détecter un déplacement en translation du premier chariot et au moins un deuxième capteur optique apte à coopérer avec au moins un cache du deuxième chariot pour détecter un déplacement en translation du deuxième chariot,
- les capteurs optiques comportent une fourche optique dont une branche porte au moins un émetteur et une branche porte au moins un récepteur, en regard de l'émetteur,
- au moins un chariot comporte un cache formé par l'extrémité d'une patte venant de matière avec le corps du chariot,
- au moins un chariot comporte deux caches agencés pour pouvoir défiler entre deux émetteurs et deux récepteurs d'un capteur optique du dispositif de commande électrique,
- au moins un chariot comporte un premier et un deuxième caches formés dans une bordure ajourée venant de matière avec le corps dudit chariot,
- le dispositif de commande électrique est configuré pour commander l'ouverture et/ou la fermeture d'un ouvrant du véhicule automobile.

D'autres caractéristiques et avantages de l'invention ressortiront de la description suivante, donnée à titre d'exemple et sans caractère limitatif, en regard des dessins annexés sur lesquels :
- la figure 1 montre une vue schématique et en perspective d'un dispositif de commande électrique pour véhicule automobile,
- la figure 2 montre une vue en partie de dessous du dispositif de commande électrique de la figure 1,
- la figure 3 montre des éléments du dispositif de commande électrique de la figure 1,
- la figure 4 montre un exemple de réalisation du suiveur de came,
- la figure 5 montre un premier chariot du dispositif de commande électrique de la figure 1 coopérant avec un premier capteur optique,
- la figure 6 montre un deuxième chariot du dispositif de commande électrique de la figure 1 coopérant avec un deuxième capteur optique,
- la figure 7 montre une vue de face d'une plaquette portant une surface de commande,
- la figure 8a illustre de manière schématique les directions des rainures de guidage de la surface de commande de la figure 7,
- la figure 8b montre un autre exemple de surface de came,
- la figure 8c montre un autre exemple de surface de came,
- la figure 8d montre un autre exemple de surface de came,
- la figure 9a montre des éléments du dispositif de commande électrique de la figure 1 avec le levier en position de repos,
- la figure 9b montre une vue similaire à la figure 9a après rotation de la manette dans le sens antihoraire,
- la figure 9c montre une vue similaire à la figure 9a après rotation de la manette dans le sens horaire, et
- la figure 9d montre une vue similaire à la figure 9a après translation « arrière » de la manette.

Sur toutes les figures, les mêmes éléments portent les mêmes numéros de référence.

Sur ces figures, les éléments identiques portent les mêmes numéros de référence. Les réalisations suivantes sont des exemples. Bien que la description se réfère à un ou plusieurs modes de réalisation, ceci ne signifie pas nécessairement que chaque référence concerne le même mode de réalisation, ou que les caractéristiques s'appliquent seulement à un seul mode de réalisation. De simples caractéristiques de différents modes de réalisation peuvent également être combinées pour fournir d'autres réalisations.

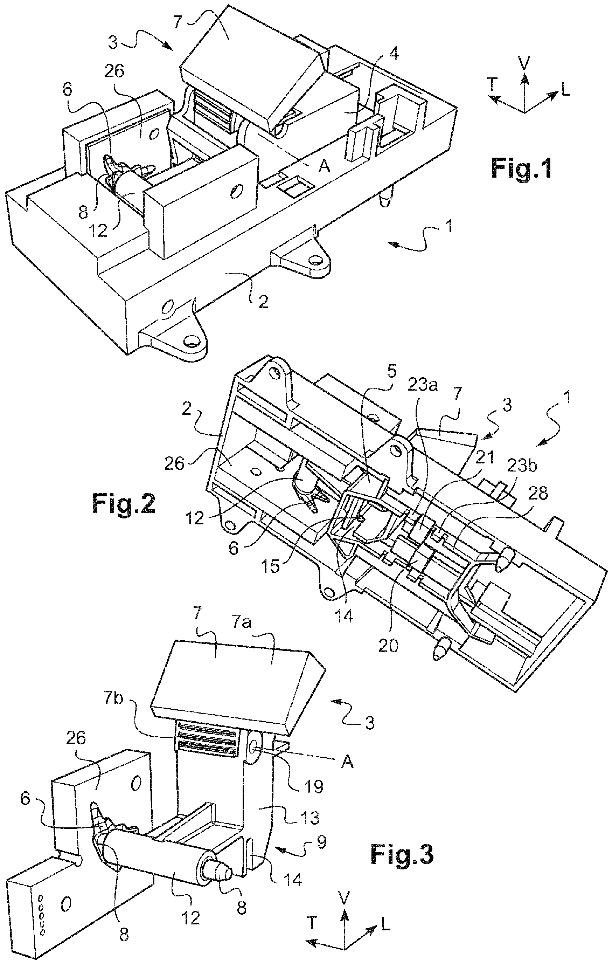

On désigne les directions longitudinale, verticale et transversale indiquées sur la figure 1 par le trièdre (L, V, T). Le plan horizontal correspond au plan (L, T).

Les figures 1 et 2 montrent un dispositif de commande électrique 1 pour véhicule automobile, par exemple agencé dans une portière ou dans la console centrale de l'habitacle entre les sièges conducteur et passager ou dans le plafonnier de l'habitacle. Le dispositif de commande électrique 1 peut bien sûr prendre n'importe quelle orientation dans l'espace, il peut par exemple être retourné de 180° par rapport à l'orientation indiquée sur les figures pour être intégré dans le plafonnier.

Le dispositif de commande électrique 1 permet à un utilisateur de commander au moins un organe du véhicule automobile, telle que l'ouverture et/ou la fermeture d'un ouvrant, comme le toit, les vitres, les cloisons, le coffre, les portes du véhicule ou la trappe à essence du véhicule.

Le dispositif de commande électrique 1 comporte un socle 2, un levier 3, un premier et un deuxième chariots 4, 5 mobiles en translation dans le socle 2 et au moins une surface de came 6 portée par le socle 2.

Le levier 3 comporte une manette 7 à une première extrémité, un axe de rotation A et au moins un suiveur de came 8 à une deuxième extrémité.

L'axe de rotation A s'étend dans la direction transversale T. Le levier 3 est monté pivotant autour de l'axe de rotation A dans le premier chariot 4, la manette 7 et le suiveur de came 8 pouvant pivoter autour de l'axe de rotation A.

En outre, le levier 3 coopère avec le deuxième chariot 5 de manière que la rotation de la manette 7 entraine une translation du deuxième chariot 5 dans le socle 2 et de manière que la translation de la manette 7 entraine une translation du deuxième chariot 5 dans le socle 2.

Selon un exemple de réalisation mieux visible sur la figure 3, le levier 3 comporte une embase 9 en forme générale d'équerre dont une première extrémité porte la manette 7 et une deuxième extrémité présente une forme de tube 12, portant deux suiveurs de came 8 symétriquement opposés coopérant avec une surface de came 6 respective.

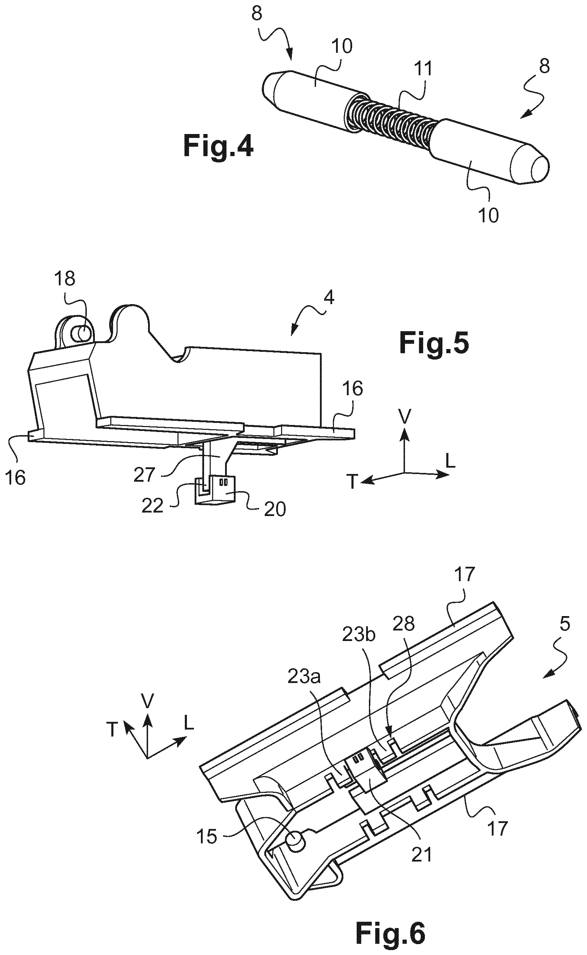

Le suiveur de came 8 s'étend selon un axe transversal T, perpendiculaire à la surface de came 6. Par exemple et comme mieux visible sur la figure 4, le suiveur de came 8 comporte un plot 10 par exemple cylindrique à bout arrondi, sollicité élastiquement en saillie à l'encontre de la surface de came 6 par un organe de rappel 11, tel qu'un ressort hélicoïdal en compression.

Le levier 3 comporte ainsi par exemple deux suiveurs de came 8, symétriquement opposés et alignés suivant la direction transversale T, perpendiculaire à la direction de translation L. Les deux suiveurs de came 8 peuvent ainsi comporter un organe de rappel 11 commun, reçu à l'intérieur de plots 10 creux. La deuxième extrémité de l'embase 9 du levier 3 peut présenter une forme de tube 12, s'étendant dans la direction transversale T pour loger et guider l'organe de rappel 11 et les plots 10. Les deux suiveurs de came 8 coopèrent avec une surface de came 6 respective, les surfaces de came 6 étant montées en regard dans le socle 2. Deux surfaces de came 6 identiques agencées symétriquement permet un meilleur équilibrage latéral des chariots 4, 5.

La manette 7 fait saillie du socle 2. Elle peut présenter une première partie de préhension 7a surélevée de forme inclinée et dégagée en dessous permettant notamment une manipulation intuitive par l'utilisateur pour déplacer le levier 3 en pivotement et une deuxième partie de préhension 7b destinée à pousser le levier 3 en translation.

L'embase 9 peut comporter un passage 13, par exemple de forme générale parallélépipédique, pour recevoir un guide de lumière (non représenté), s'étendant verticalement entre une source de lumière montée sur une carte électronique (non représentée) et la manette 7. La manette 7 peut comporter au moins une zone laissant passer la lumière, par exemple en matériau transparent ou translucide, représentant par exemple un symbole visuel ou un pictogramme pouvant ainsi être rétroéclairé.

Pour que la rotation et la translation de la manette 7 entrainent la translation du deuxième chariot 5, on peut prévoir que le levier 3 et le deuxième chariot 5 comportent au moins un orifice oblong 14 s'étendant dans un plan (L, V) orthogonal à la direction transversale T et au moins un pion cylindrique 15 saillant dans la direction transversale T, coopérant avec l'orifice oblong 14.

Par exemple et comme visible sur les figures 2, 3 et 6, le levier 3 comporte deux orifices oblongs 14 s'étendant verticalement en position de repos et le deuxième chariot 5 comporte deux pions cylindriques 15 saillant dans la direction transversale T. Les orifices oblongs 14 sont par exemple ménagés à l'extrémité du passage 13 de l'embase 9, sur des parois en vis-à-vis.

Le premier et le deuxième chariots 4, 5 sont montés mobiles en translation dans le socle 2 indépendamment l'un de l'autre.

Pour cela, le socle 2 peut comporter des moyens de guidage en translation, tels qu'un dispositif à rails coopérant avec des nervures longitudinales 16 du premier chariot 4 (figure 5), pour guider le déplacement en translation du premier chariot 4 dans le socle 2 (ou inversement). Egalement, le socle 2 peut comporter des moyens de guidage en translation, tels qu'un dispositif à rails coopérant avec des nervures longitudinales 17 du deuxième chariot 5 (ou inversement), pour guider le déplacement en translation du deuxième chariot 5 dans le socle 2.

L'axe de rotation A du levier 3 est par exemple réalisé par deux pions cylindriques 18 en vis-à-vis coopérant avec des trous 19 complémentaires. Les deux pions cylindriques 18 sont par exemple formés dans le premier chariot 4 au niveau d'un logement destiné à recevoir le levier 3 (figure 5). Les trous 19 complémentaires sont alors ménagés dans l'embase 9 (figure 3), par exemple sous la première partie de préhension 7a de la manette 7 destinée à entrainer le levier 3 en pivotement, à l'arrière de la deuxième partie de préhension 7b destinée à entrainer le levier 3 en translation. L'axe de rotation A n'est pas centré sous la première partie de préhension 7a mais est situé à l'avant sur les figures, au plus près de la deuxième partie de préhension 7b. Par ailleurs, l'axe de rotation A croise perpendiculairement la direction dans laquelle s'étendent les orifices oblongs 14.

Le premier chariot 4 peut comporter au moins un cache 22 apte à coopérer avec un premier capteur optique 20 du dispositif de commande électrique 1 pour détecter un déplacement en translation du premier chariot 4. De même, le deuxième chariot 5 peut comporter au moins un cache 23a, 23b apte à coopérer avec un deuxième capteur optique 21 du dispositif de commande électrique 1 pour détecter un déplacement en translation du deuxième chariot 5.

Les capteurs optiques 20, 21 comportent par exemple une fourche optique dont une branche porte au moins un émetteur et une branche porte au moins un récepteur en regard de l'émetteur. L'émetteur émet un faisceau pouvant être détecté par l'émetteur en l'absence d'obstacle opaque entre l'émetteur et le récepteur. Un capteur optique peut aussi comporter deux émetteurs et deux détecteurs, de manière à pouvoir détecter un sens de déplacement en fonction de l'ordre dans lequel les faisceaux sont coupés.

Ainsi, dans l'exemple illustré, on prévoit par exemple que le premier chariot 4 comporte un cache 22 formé par l'extrémité d'une patte 27 venant de matière avec le corps du premier chariot 4 (figure 5). La patte 27 s'étend verticalement, à travers une fente longitudinale du deuxième chariot 5, pour pouvoir défiler entre les branches de la fourche du premier capteur optique 20 lorsque le premier chariot 4 se déplace en translation.

Le deuxième chariot 5 peut comporter deux caches 23a, 23b, alignés dans la direction de translation et séparés par un trou, formant une bordure ajourée 28. La bordure ajourée 28 vient de matière avec le corps du deuxième chariot 5. Le deuxième capteur optique 21 comporte une fourche présentant deux émetteurs et deux détecteurs entre lesquels la bordure ajourée 28 peut défiler.

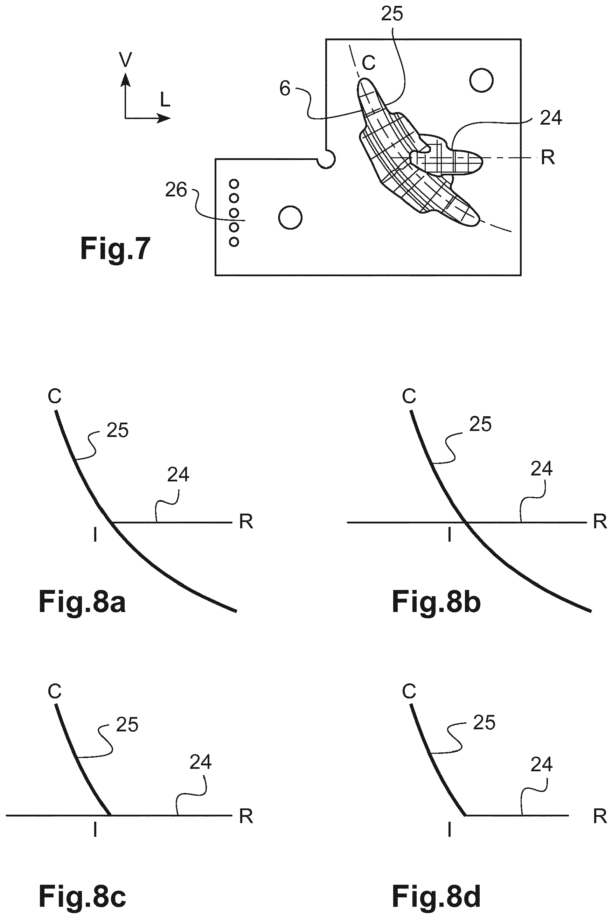

Nous allons maintenant décrire la forme de la surface de came 6 en référence aux figures 7, 8a, 8b, 8c et 8d.

La surface de came 6 présente une première rainure de guidage 24 d'orientation rectiligne R et une deuxième rainure de guidage 25 s'inscrivant dans une forme circulaire C, les rainures de guidage 24, 25 étant sécantes.

Plus précisément et comme on peut le voir sur la figure 7, la surface de came 6 s'inscrit dans le plan (V, L), la première rainure de guidage 24 d'orientation rectiligne R s'étendant dans la direction longitudinale L du dispositif de commande électrique 1 et la forme circulaire C de la deuxième rainure de guidage 25 s'inscrivant dans le plan (V, L).

Le levier 3 coopère d'une part, avec les surfaces de came 6 et d'autre part, avec le premier et le deuxième chariots 4, 5, pour que la rotation du levier 3 entraine le déplacement en translation du deuxième chariot 5 dans le socle 2 et que la translation du levier 3 entraine en translation le premier et le deuxième chariots 4, 5 dans le socle 2.

La forme en croix (ou en « V » ou en « Y ») de la surface de came 6 permet une sélection du déplacement du levier 3, soit en translation, soit en pivotement. On peut ainsi gérer jusqu'à quatre mouvements de la manette 7 avec des indexages spécifiques sans que l'un des mouvements ne vienne interférer avec l'autre lors de l'actionnement du dispositif 1. En outre, la rotation du levier 3 est transformée en déplacement linéaire, permettant au dispositif de commande électrique 1 de s'animer par des coulissements de chariots 4, 5, simples à réaliser. L'utilisation d'une surface de came 6 et de deux chariots 4, 5 permet de réduire de façon importante le nombre de pièces du dispositif de commande électrique 1 et donc son encombrement et son coût.

Selon un exemple de réalisation, une rainure de guidage 24, 25 croise l'autre rainure de guidage en son milieu. Ainsi et comme on l'a schématisé sur la figure 8a, la première rainure de guidage 24 d'orientation rectiligne R croise la deuxième rainure de guidage 25 s'inscrivant dans une forme circulaire C au milieu de la deuxième rainure de guidage 25.

Selon un autre exemple représenté sur la figure 8b, la première rainure de guidage 24 d'orientation rectiligne R et la deuxième rainure de guidage 25 s'inscrivant dans une forme circulaire C se croisent chacune en leur milieu.

Selon encore un autre exemple représenté sur la figure 8c, la première rainure de guidage 24 d'orientation rectiligne R croise la deuxième rainure de guidage 25 s'inscrivant dans une forme circulaire C au milieu de la première rainure de guidage 24.

Selon un exemple de réalisation, une rainure de guidage 24, 25 croise l'autre rainure de guidage à une de ses extrémités. Ainsi et comme on l'a schématisé sur la figure 8a, la première rainure de guidage 24 d'orientation rectiligne R croise la deuxième rainure de guidage 25 s'inscrivant dans une forme circulaire C à une extrémité de la première rainure de guidage 24.

Selon un autre exemple représenté sur la figure 8c, la première rainure de guidage 24 d'orientation rectiligne R croise la deuxième rainure de guidage 25 s'inscrivant dans une forme circulaire C à une extrémité de la deuxième rainure de guidage 25.

Selon encore un autre exemple de réalisation représenté sur la figure 8d, la première rainure de guidage 24 d'orientation rectiligne R et la deuxième rainure de guidage 25 s'inscrivant dans une forme circulaire C se croisent chacune à une de leurs extrémités.

Selon un exemple de réalisation, au moins une rainures de guidage 24, 25 comporte au moins un creux et/ou un relief d'indexage. On prévoit ainsi par exemple au moins deux positions d'indexage pour chaque rainure de guidage 24, 25, avec au moins l'indexage de la position de l'intersection I entre les deux rainures de guidage 24, 25. La coopération entre la surface de came 6 et le suiveur de came 8 permet ainsi de générer un retour à l'utilisateur en plus de guider le levier 3 en pivotement ou en translation. Par ailleurs, l'indexage mécanique est ainsi très robuste. Il peut supporter de très hautes températures, telles que des températures supérieures à 100°C.

La surface de came 6 est par exemple ménagée dans une plaquette 26, distincte du socle 2, montée et fixée dans le socle 2. On peut ainsi plus facilement moduler la forme des rainures de guidage 24, 25 selon les modèles des véhicules en changeant seulement la plaquette 26. De plus, on peut prévoir des plaquettes 26 en matériau adapté au frottement, tel qu'en Polyoxyméthylène (ou « POM »), tandis que les autres éléments de la manette 7 et/ou du socle 2 peuvent être réalisés en matériaux plastiques standards moins couteux, tel que PC (pour PolyCarbonate) et/ou ABS/PC (pour Acrylonitrile Butadiène Styrène / PolyCarbonate).

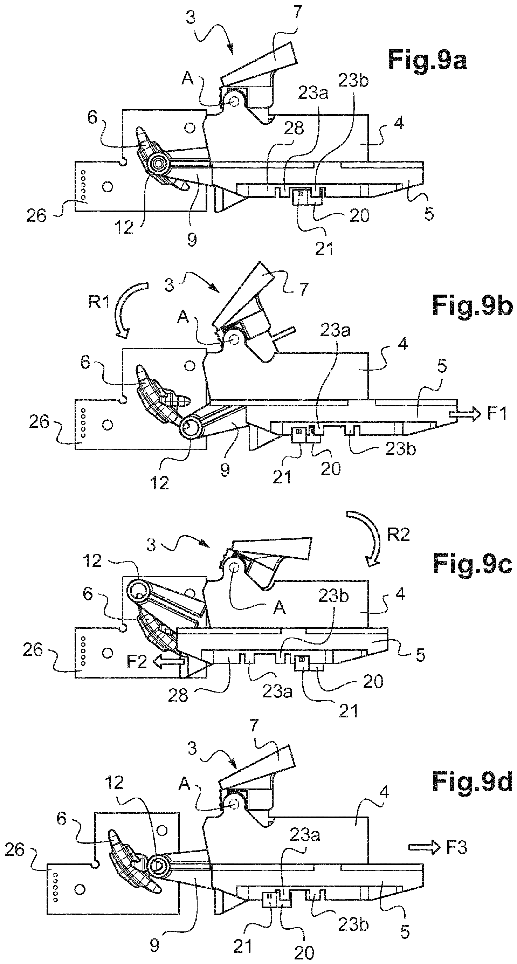

Ainsi, en position de repos (figure 9a), le suiveur de came 8 est positionné à l'intersection I des rainures de guidages 24, 25. La bordure ajourée 28 du deuxième chariot 5 positionne le trou situé entre les deux caches 23 entre les émetteurs et les récepteurs de la fourche du deuxième capteur optique 21. Le cache 22 de la patte 27 du premier chariot 4 est positionné dans la fourche du premier capteur optique 20.

Lorsque l'utilisateur pivote la manette 7 en rotation antihoraire (flèche R1 sur la figure 9b), les suiveurs de came 8 suivent les deuxièmes rainures de guidage 25 de forme circulaire jusqu'à venir en butée à des premières extrémités, faisant coulisser le deuxième chariot 5 vers l'arrière (flèche F1).

La bordure ajourée 28 défile alors vers l'arrière dans la fourche du deuxième capteur optique 21, déplaçant le premier cache 23a entre les émetteurs et les récepteurs de la fourche du deuxième capteur optique 21. La coupure des faisceaux par le premier cache 23a permet de déterminer que le deuxième chariot 5 s'est déplacé. Le faisceau situé le plus à gauche sur les figures est coupé en premier, ce qui permet de déterminer le sens de déplacement du deuxième chariot 5.

La rotation de la manette 7 n'entraine pas le premier chariot 4 puisque la manette 7 est montée pivotante dans le premier chariot 4. Le cache 22 de la patte 27 du premier chariot 4 reste donc positionné dans la fourche du premier capteur optique 20. L'absence de modification du signal de sortie du premier capteur optique 20 permet de déterminer que le premier chariot 4 ne s'est pas déplacé. La modification du signal de sortie du deuxième capteur optique 21 seule, permet de déduire que l'utilisateur a pivoté la manette 7.

Lorsque l'utilisateur pivote la manette 7 en rotation horaire (flèche R2 sur la figure 9c), les suiveurs de came 8 suivent les deuxièmes rainures de guidage 25 de forme circulaire jusqu'à venir en butée à des extrémités opposées, faisant coulisser le deuxième chariot 5 vers l'avant (flèche F2).

La bordure ajourée 28 défile alors vers l'avant dans la fourche du deuxième capteur optique 21, déplaçant le deuxième cache 23b entre les émetteurs et les récepteurs de la fourche du deuxième capteur optique 21. La coupure des faisceaux par le deuxième cache 23b permet de déterminer que le deuxième chariot 5 s'est déplacé. Le faisceau situé le plus à droite sur les figures est coupé en premier, ce qui permet de déterminer le sens de déplacement du deuxième chariot 5. Comme dans le cas précédent, l'absence de modification du signal de sortie du premier capteur optique 20 permet de déterminer que l'utilisateur a pivoté la manette 7.

Lorsque l'utilisateur recule la manette 7 (figure 9d), les suiveurs de came 8 suivent la première rainure de guidage 24 d'orientation rectiligne jusqu'à venir en butée à leurs extrémités, faisant coulisser les deux chariots 4, 5 vers l'arrière (flèche F3).

La bordure ajourée 28 défile alors vers l'arrière dans la fourche du deuxième capteur optique 21, déplaçant le premier cache 23a entre les émetteurs et les récepteurs de la fourche du deuxième capteur optique 21. L'extrémité de la patte 27 se déplace hors de la fourche du premier capteur optique 20. Les signaux de sortie du premier et du deuxième capteur optique 21 sont alors modifiés, permettant de déterminer que les deux chariots 4, 5 se sont déplacés, ce qui correspond à un mouvement de translation de la manette 7.

On peut ainsi déterminer si le deuxième chariot 5 ou les deux chariots 4, 5 se sont déplacés par codage optique et ainsi déterminer si l'utilisateur a pivoté la manette 7 vers l'avant ou l'arrière ou s'il l'a déplacée en translation.

## Revendications

1. Dispositif de commande électrique (1) pour véhicule automobile comprenant un socle (2) comportant :
- un levier (3) dont une première extrémité porte une manette (7) et une deuxième extrémité porte au moins un suiveur de came (8),
- un premier et un deuxième chariots (4, 5) mobiles dans le socle (2),
- au moins une surface de came (6) présentant une première rainure de guidage et une deuxième rainure de guidage (25),
**caractérisé en ce que** :
- le levier (3) est monté pivotant dans le premier chariot (4) et coopère avec le deuxième chariot (5) de manière que la rotation de la manette (7) entraine une translation du deuxième chariot (5) dans le socle (2) et de manière que la translation de la manette (7) entraine une translation du deuxième chariot (5) dans le socle (2), et
- la première rainure de guidage (24) est d'orientation rectiligne et la deuxième rainure de guidage (25) s'inscrit dans une forme circulaire, les rainures de guidage (24, 25) étant sécantes, le levier (3) coopérant avec la surface de came (6) et le premier et le deuxième chariots (4, 5) pour que la rotation du levier (3) entraine le déplacement en translation du deuxième chariot (5) dans le socle (2) et pour que la translation du levier (3) entraine en translation les deux chariots (4, 5) dans le socle (2).

2. Dispositif de commande électrique (1) selon la revendication précédente, **caractérisé en ce qu'**une rainure de guidage (24, 25) rencontre l'autre rainure de guidage (24, 25) en son milieu.

3. Dispositif de commande électrique (1) selon l'une des revendications précédentes, **caractérisé en ce qu'**une rainure de guidage (24, 25) rencontre l'autre rainure de guidage (24, 25) à une de ses extrémités.

4. Dispositif de commande électrique (1) selon l'une des revendications précédentes, **caractérisé en ce qu'**au moins une rainure de guidage (24, 25) comporte au moins un creux et/ou un relief d'indexage.

5. Dispositif de commande électrique (1) selon l'une des revendications précédentes, **caractérisé en ce que** la surface de came (6) est ménagée dans une plaquette (26) montée et fixée dans un socle (2) du dispositif de commande électrique (1).

6. Dispositif de commande électrique (1) selon l'une des revendications précédentes, **caractérisé en ce que** le levier (3) et le deuxième chariot (5) comportent au moins un orifice oblong (14) et au moins un pion cylindrique (15), l'orifice oblong (14) s'étendant dans un plan (L, V) orthogonal à la direction transversale (T) et coopérant avec le pion cylindrique (15) saillant dans la direction transversale (T).

7. Dispositif de commande électrique (1) selon l'une des revendications précédentes, **caractérisé en ce que** le levier (3) comporte une embase (9) en forme générale d'équerre dont une première extrémité porte la manette (7) et une deuxième extrémité présente une forme de tube (12), portant deux suiveurs de came (8) symétriquement opposés coopérant avec une surface de came (6) respective.

8. Dispositif de commande électrique (1) selon l'une des revendications précédentes, **caractérisé en ce qu'**il comporte au moins un premier capteur optique (20) apte à coopérer avec au moins un cache (22) du premier chariot (4) pour détecter un déplacement en translation du premier chariot (4) et au moins un deuxième capteur optique (21) apte à coopérer avec au moins un cache (23a, 23b) du deuxième chariot (5) pour détecter un déplacement en translation du deuxième chariot (5).

9. Dispositif de commande électrique (1) selon la revendication précédente, **caractérisé en ce que** les capteurs optiques (20, 21) comportent une fourche optique dont une branche porte au moins un émetteur et une branche porte au moins un récepteur en regard de l'émetteur.

10. Dispositif de commande électrique (1) selon l'une des revendications 8 ou 9, **caractérisé en ce qu'**au moins un chariot (4) comporte un cache (22) formé par l'extrémité d'une patte (27) venant de matière avec le corps du chariot (4).

11. Dispositif de commande électrique (1) selon l'une des revendications 8 à 10, **caractérisé en ce qu'**au moins un chariot (5) comporte deux caches (23a, 23b) agencés pour pouvoir défiler entre deux émetteurs et deux récepteurs d'un capteur optique (21) du dispositif de commande électrique (1).

12. Dispositif de commande électrique (1) selon l'une des revendications 8 à 11, **caractérisé en ce qu'**au moins un chariot (5) comporte un premier et un deuxième caches (23a, 23b) formés dans une bordure ajourée (28) venant de matière avec le corps dudit chariot (5).

13. Dispositif de commande électrique (1) selon l'une des revendications précédentes, **caractérisé en ce qu'**il est configuré pour commander l'ouverture et/ou la fermeture d'un ouvrant du véhicule automobile.

## Patentansprüche

1. Elektrische Steuerungsvorrichtung (1) für ein Kraftfahrzeug, umfassend einen Sockel (2), der Folgendes aufweist:
- einen Hebel (3), von dem ein erstes Ende einen Griff (7) trägt und ein zweites Ende mindestens einen Nockenverfolger (8) trägt,
- einen ersten und einen zweiten Schlitten (4, 5), die in dem Sockel (2) bewegbar sind,
- mindestens eine Nockenfläche (6), die eine erste Führungsrille und eine zweite Führungsrille (25) aufweist,
**dadurch gekennzeichnet, dass**:
- der Hebel (3) kippend in dem ersten Schlitten (4) angebracht ist und mit dem zweiten Schlitten (5) derart zusammenwirkt, dass die Rotation des Griffs (7) eine Translation des zweiten Schlittens (5) in dem Sockel (2) bewirkt und derart, dass die Translation des Griffs (7) eine Translation des zweiten Schlittens (5) in dem Sockel (2) bewirkt, und
- die erste Führungsrille (24) gerade ausgerichtet ist und die zweite Führungsrille (25) eine kreisrunde Form beschreibt, wobei die Führungsrillen (24, 25) schneidend sind, wobei der Hebel (3) mit der Nockenfläche (6) und dem ersten und dem zweiten Schlitten (4, 5) zusammenwirkt, damit die Rotation des Hebels (3) die translatorische Verlagerung des zweiten Schlittens (5) in dem Sockel (2) bewirkt und damit die Translation des Hebels (3) die zwei Schlitten (4, 5) in dem Sockel (2) translatorisch mitnimmt.

2. Elektrische Steuerungsvorrichtung (1) nach vorangehendem Anspruch, **dadurch gekennzeichnet, dass** eine Führungsrille (24, 25) die andere Führungsrille (24, 25) in ihrer Mitte trifft.

3. Elektrische Steuerungsvorrichtung (1) nach einem der vorangehenden Ansprüche, **dadurch gekennzeichnet, dass** eine Führungsrille (24, 25) die andere Führungsrille (24, 25) an einem ihrer Enden trifft.

4. Elektrische Steuerungsvorrichtung (1) nach einem der vorangehenden Ansprüche, **dadurch gekennzeichnet, dass** mindestens eine Führungsrille (24, 25) mindestens eine Vertiefung und/oder ein Indexierungsrelief aufweist.

5. Elektrische Steuerungsvorrichtung (1) nach einem der vorangehenden Ansprüche, **dadurch gekennzeichnet, dass** die Nockenfläche (6) in einer Platte (26) eingearbeitet ist, die in einem Sockel (2) der elektrischen Steuerungsvorrichtung (1) angebracht und befestigt ist.

6. Elektrische Steuerungsvorrichtung (1) nach einem der vorangehenden Ansprüche, **dadurch gekennzeichnet, dass** der Hebel (3) und der zweite Schlitten (5) mindestens ein Langloch (14) und mindestens einen zylindrischen Stift (15) aufweisen, wobei sich das Langloch (14) in einer zu der Querrichtung (T) orthogonalen Ebene (L, V) erstreckt und mit dem hervorstehenden zylindrischen Stift (15) in der Querrichtung (T) zusammenwirkt.

7. Elektrische Steuerungsvorrichtung (1) nach einem der vorangehenden Ansprüche, **dadurch gekennzeichnet, dass** der Hebel (3) eine allgemein winkelförmige Basis (9) aufweist, von der ein erstes Ende den Griff (7) trägt und ein zweites Ende eine Rohrform (12) aufweist, das zwei symmetrisch gegenüberliegende Nockenverfolger (8) trägt, die mit einer jeweiligen Nockenfläche (6) zusammenwirken.

8. Elektrische Steuerungsvorrichtung (1) nach einem der vorangehenden Ansprüche, **dadurch gekennzeichnet, dass** sie mindestens einen ersten optischen Sensor (20) aufweist, der imstande ist, mit mindestens einer Abdeckung (22) des ersten Schlittens (4) zusammenzuwirken, um eine translatorische Verlagerung des ersten Schlittens (4) zu ermitteln, und mindestens einen zweiten optischen Sensor (21), der imstande ist, mit mindestens einer Abdeckung (23a, 23b) des zweiten Schlittens (5) zusammenzuwirken, um eine translatorische Verlagerung des zweiten Schlittens (5) zu ermitteln.

9. Elektrische Steuerungsvorrichtung (1) nach vorangehendem Anspruch, **dadurch gekennzeichnet, dass** die optischen Sensoren (20, 21) eine optische Gabel aufweisen, von der eine Abzweigung mindestens einen Sender trägt und eine Abzweigung mindestens einen Empfänger gegenüber dem Sender trägt.

10. Elektrische Steuerungsvorrichtung (1) nach einem der Ansprüche 8 oder 9, **dadurch gekennzeichnet, dass** mindestens ein Schlitten (4) eine Abdeckung (22) aufweist, die von dem Ende eines Fußes (27) gebildet ist, der mit dem Körper des Schlittens (4) einstückig ist.

11. Elektrische Steuerungsvorrichtung (1) nach einem der Ansprüche 8 bis 10, **dadurch gekennzeichnet, dass** mindestens ein Schlitten (5) zwei Abdeckungen (23a, 23b) aufweist, die eingerichtet sind, um zwischen zwei Sendern und zwei Empfängern eines optischen Sensors (21) der elektrischen Steuerungsvorrichtung (1) vorbeiziehen zu können.

12. Elektrische Steuerungsvorrichtung (1) nach einem der Ansprüche 8 bis 11, **dadurch gekennzeichnet, dass** mindestens ein Schlitten (5) eine erste und eine zweite Abdeckung (23a, 23b) aufweist, die in einem durchbrochenen Rand (28) ausgebildet sind, der mit dem Körper des Schlittens (5) einstückig ist.

13. Elektrische Steuerungsvorrichtung (1) nach einem der vorangehenden Ansprüche, **dadurch gekennzeichnet, dass** sie ausgelegt ist, um das Öffnen und/oder das Schließen eines Flügels des Kraftfahrzeugs zu steuern.

## Claims

1. Electrical control device (1) for a motor vehicle, comprising a mount (2) having:
- a lever (3), a first end of which bears a lever handle (7) and a second end of which bears at least one cam follower (8),
- a first and a second carriage (4, 5) that are movable in the mount (2),
- at least one cam surface (6) having a first guide slot and a second guide slot (25),
**characterized in that**:
- the lever (3) is mounted in a pivotable manner in the first carriage (4) and cooperates with the second carriage (5) such that the rotation of the lever handle (7) causes the second carriage (5) to move in translation in the mount (2) and such that the movement in translation of the lever handle (7) causes the second carriage (5) to move in translation in the mount (2), and
- the first guide slot (24) is oriented in a rectilinear manner and the second guide slot (25) is inscribed in a circular shape, the guide slots (24, 25) intersecting one another, the lever (3) cooperating with the cam surface (6) and the first and the second carriages (4, 5) such that the rotation of the lever (3) causes the second carriage (5) to move in translation in the mount (2) and such that the movement in translation of the lever (3) causes the two carriages (4, 5) to move in translation in the mount (2).

2. Electrical control device (1) according to the preceding claim, **characterized in that** one guide slot (24, 25) meets the other guide slot (24, 25) at its middle.

3. Electrical control device (1) according to either of the preceding claims, **characterized in that** one guide slot (24, 25) meets the other guide slot (24, 25) at one of its ends.

4. Electrical control device (1) according to one of the preceding claims, **characterized in that** at least one guide slot (24, 25) has at least one indexing relief and/or recess.

5. Electrical control device (1) according to one of the preceding claims, **characterized in that** the cam surface (6) is formed in a plate (26) mounted and secured in a mount (2) of the electrical control device (1).

6. Electrical control device (1) according to one of the preceding claims, **characterized in that** the lever (3) and the second carriage (5) have at least one elongate orifice (14) and at least one cylindrical pin (15), the elongate orifice (14) extending in a plane (L, V) orthogonal to the transverse direction (T) and cooperating with the cylindrical pin (15), which protrudes in the transverse direction (T).

7. Electrical control device (1) according to one of the preceding claims, **characterized in that** the lever (3) has a base (9) in the overall shape of a bracket, a first end of which bears the lever handle (7) and a second end of which has a tubular shape (12), bearing two, symmetrically opposite cam followers (8) that cooperate with respective cam surfaces (6).

8. Electrical control device (1) according to one of the preceding claims, **characterized in that** it has at least one first optical sensor (20) that is able to cooperate with at least one cover (22) of the first carriage (4) in order to detect a movement in translation of the first carriage (4), and at least one second optical sensor (21) that is able to cooperate with at least one cover (23a, 23b) of the second carriage (5) in order to detect a movement in translation of the second carriage (5).

9. Electrical control device (1) according to the preceding claim, **characterized in that** the optical sensors (20, 21) have an optical fork, one arm of which bears at least one transmitter and one arm of which bears at least one receiver facing the transmitter.

10. Electrical control device (1) according to either of Claims 8 and 9, **characterized in that** at least one carriage (4) has a cover (22) formed by the end of a lug (27) formed integrally with the body of the carriage (4).

11. Electrical control device (1) according to one of Claims 8 to 10, **characterized in that** at least one carriage (5) has two covers (23a, 23b) designed to be able to travel between two transmitters and two receivers of an optical sensor (21) of the electrical control device (1).

12. Electrical control device (1) according to one of Claims 8 to 11, **characterized in that** at least one carriage (5) has a first and a second cover (23a, 23b) that are formed in a perforated border (28) formed integrally with the body of said carriage (5) .

13. Electrical control device (1) according to one of the preceding claims, **characterized in that** it is configured to control the opening and/or closing of a motor vehicle door.
